# EUROPEAN PATENT SPECIFICATION

(11) **EP 2 481 489 B1**
(45) Date of publication and mention of the grant of the patent: **20.08.2014**
(21) Application number: 12002879.0
(22) Date of filing: 14.04.2004
(51) Int. Cl.: B08B 7/00, B08B 1/00

(54) **Cleaning sheet, carrying member with a cleaning function and method of cleaning substrate processing equipment**
Reinigungstuch, Trägerelement mit einer Reinigungsfunktion und Verfahren zur Reinigung einer Substratverarbeitungsausrüstung
Feuille de nettoyage, élément de support avec fonction de nettoyage et procédé de nettoyage d'équipement de traitement de substrat

(30) Priority: 14.04.2003 JP 2003108584; 19.05.2003 JP 2003139768; 28.01.2004 JP 2004019523
(43) Date of publication of application: 01.08.2012
(62) Divisional of application: 10016058.9
(73) Proprietor: Nitto Denko Corporation, Ibaraki-shi Osaka 567-8680 (JP)
(72) Inventor: Terada, Yoshio, Ibaraki-shi Osaka (JP); Namikawa, Makoto, Ibaraki-shi Osaka (JP); Uenda, Daisuke, Ibaraki-shi Osaka (JP); Funatsu, Asami, Ibaraki-shi Osaka (JP)
(74) Representative: Grünecker, Kinkeldey, Stockmair & Schwanhäusser

(56) References cited:
- EP-A1- 1 106 136
- WO-A-03/052045
- GB-A- 2 170 427
- US-B1- 6 277 457

## Description

The present invention relates to a cleaning sheet comprising a cleaning layer and a releasable protective film, a carrying member and a method of cleaning a substrate processing equipment using such a cleaning sheet.

In various substrate processing equipments, various conveyance systems and bases are conveyed in physical contact with each other. During this procedure, when the bases or conveyance systems have foreign matters attached thereto, the subsequent bases are sequentially contaminated. This makes it necessary that the operation of the substrate processing equipment be regularly suspended for cleaning, causing the drop of operating efficiency or requiring much labor.

In order to solve these problems, a method which comprises conveying a base having a tacky material fixed thereto into a substrate processing equipment to remove foreign matters from the interior of the substrate processing equipment (Patent Reference 1) and a method which comprises conveying a tabular member to remove foreign matters from the back surface of a base (Patent Reference 2) have been proposed. These methods eliminate the necessity of suspending the operation of the substrate processing equipment for cleaning, causing no drop of operating efficiency or requiring no much labor. In particular, the former method is superior in the capacity of removing foreign matters.

In the above proposed methods, particularly the former method, which is superior in the capacity of removing foreign matters, i.e., method involving the use of a tacky material, it is normally practiced to laminate a releasable protective film on the surface of the cleaning layer for the sake of prevention of contamination of cleaning layer or better handleability. There are various such protective films. As a protective film having an excellent releasability there is widelyused, e.g., a polyester film treated with a silicone-based releasability-providing agent.

However, a cleaning member comprising such a protective film is disadvantageous in that a silicone compound which is a releasability-providing agent is moved and transferred to the cleaning layer. When the cleaning member is then conveyed into a substrate processing equipment with the protective film peeled off to remove foreign matters from the interior of the device, the releasability-providing agent on the cleaning layer is attached to contact portions and other areas in the device, causing the contamination of the device. As a result, the product wafer is contaminated, causing the deterioration of device properties resulting in frequent occurrence of defectives.

The former method is also disadvantageous in that when the interior of the conveying device is heated to 100°C or in high vacuo (1.33 10⁻⁷ Pa (10⁻⁹ torr)), the tacky material generates a large amount of volatile gas that contaminates the interior of the device or reduces the degree of vacuum, occasionally making it impossible to simplify the removal of foreign matters.

In particular, substrate processing equipments are mostly operated while its interior kept in high vacuo as in plasma etching device, sputtering device, dry etching device, reactive ion etching device, CVD device, etc. Therefore, when these devices are cleaned by the former method, the degree of vacuum therein is reduced.

### [Patent Reference 1]

JP-A-10-154686 (pages 2 to 4)

### [Patent Reference 2]

JP-A-11-87458 (pages 2 to 3)

An object of the invention is to provide a cleaning sheet which causes little contamination of a substrate processing equipment due to the movement and transfer of silicone to the cleaning layer when conveyed into the substrate processing equipment to remove foreign matters from the interior of the device and to provide a carrying member with a cleaning function which causes little drop of the degree of vacuum in a substrate processing equipment due to the carrying member and performs simple and secure removal of foreign matters therefrom when conveyed into the substrate processing equipment to remove foreign matters from the interior of the device.

The present applicant previously made a study of the amount of silicone attached to the cleaning layer when the protective film is peeled off the cleaning layer over the aforementioned aim. The present applicant then knew that the use of a cleaning member which attracts silicone in an amount of 0.005 g/m² or less in polydimethyl siloxane equivalence makes it possible to eliminate the contamination of the device by silicone. This knowledge was proposed as an invention (Japanese Patent Application 2001-386708).

However, a subsequent study by the inventors shows that even when the above proposed cleaning member is used, the contamination of the device by silicone moved and transferred to the cleaning layer occasionally cannot be surely prevented. The inventors made further studies to clear up the cause of the phenomenon. As a result, knowledge was obtained that there are many kinds of silicone that can be moved and transferred to the cleaning layer and when the attached amount of silicone in polydimethyl siloxane equivalence is merely limited by an ordinary analysis method, the contamination of the device by silicone occasionally cannot be surely prevented.

The inventors made wider experimental studies on the basis of this knowledge. As a result, a knowledge was obtained that when the kind of silicone that has beenmoved and transferred to the cleaning layer is analyzed by a time-of-flight secondary ion mass spectrometry to determined the relative intensity of specific fragment ions derived from silicone and the relative intensity is limited to a specific value or less, the contamination of the device by silicone can be surely prevented, making it possible to further prevent the deterioration of the properties of the device by the contamination of product wafer. Thus, the invention has been worked out.

The present applicant earlier knew that the reduction of the degree of vacuum in high vacuum substrate processing equipments as previously mentioned is caused by aliphatic or aromatic components, solvent components as contaminants and plasticizer components such as ester fumarate contained in the cleaning layer of the carrying member. A cleaning member having a gas evaporation limited to a specific value or less was then proposed as an invention (Japanese Patent Application 2000-349972).

However, a subsequent studies by the inventors showed that even when the above proposed cleaning member is used, the reduction of the degree of vacuum in the high vacuum substrate processing equipment still occurs due to the cleaning member during the conveyance of the cleaning member into the high vacuum substrate processing equipment for the purpose of removing foreign matters therefrom, occasionally disabling the use of the substrate processing equipment.

The cause of the reduction of the degree of vacuum in the high vacuum substrate processing equipment was further studied. As a result, a knowledge was obtained that the cause of the reduction of the degree of vacuum in the high vacuum vase processing device is not limited to the above proposed aliphatic or aromatic components, solvent components and plasticizer components, but the reductionof the degree of vacuum in the high vacuum vase processing device is also attributed to water content evaporated in high vacuo.

On the basis of this knowledge, the inventors reduced the water content to be evaporated in high vacuo as much as possible by heating the cleaning layer, etc. to reduce the ordinary state moisture absorption rate thereof or reducing the thickness of the cleaning layer, etc. to reduce the absolute water content thereof. As a result, it was found that these approaches make it possible to inhibit the reduction of the degree of vacuum in the high vacuum substrate processing equipment occurring when the cleaning member is conveyed in high vacuo. It was also found that this inhibiting effect can be surely exerted by limiting the time required until the degree of vacuum in the vacuum chamber at a predetermined temperature which has been temporarily reduced when the cleaning member is put therein is returned almost to the original value, making it possible to inhibit the reduction of the degree of vacuum in the actual high vacuum substrate processing equipment and hence simply and surely remove foreignmatters from the interior of the substrate processing equipment. The invention has thus been worked out.

The above object is solved by
a cleaning sheet comprising a cleaning layer and a releasable protective film laminated on the cleaning layer, wherein each of the relative intensities of the fragment ions of CH₃Si⁺, C₃H₉Si⁺, CₛH₁₅Si₂O⁺, C₅H₁₅Si₃O₃⁺, C₇H₂₁Si₃O₂⁺, CH₃SiO⁻, CH₃SiO₂⁻ and Si⁺ in the cleaning layer, when the protective film is peeled off the cleaning layer, is 0.1 or less according to time-of-flight secondary ion mass spectrometry, relative to C₂H₃⁺ in the case of positive ion or O⁻ in the case of negative ion, and
a carrying member with a cleaning function, comprising a carrying base and a cleaning layer provided on at least one side of the carrying base, said carrying base being selected from the group consisting of semiconductor wafers, bases for flat panel displays, and bases for compact disk and MR head, wherein the cleaning layer is made of a resin layer which has been polymerization-cured by an active energy source, and wherein each of the relative intensities of the fragment ions of CH₃Si⁺, C₃H₉Si⁺, C₅H₁₅Si₂O⁺, C₅H₁₅Si₃O₃⁺, C₇H₂₁Si₃O₂⁺, CH₃SiO⁻, CH₃SiO₂⁻ and Si⁺ in the cleaning layer, is 0.1 or less according to time-of flight secondary ion mass spectrometry, relative to C₂H₃⁺ in the case of positive ion or O⁻ in the case of negative ion.

Furthermore, the present invention provides a method of cleaning a substrate processing equipment which comprises conveying the cleaning sheet, or the carrying member with a cleaning function defined in the present invention into a substrate processing equipment.

Preferably the cleaning layer has substantially no adhesive strength.

It is further preferred that the cleaning sheet comprises a support, wherein the cleaning layer is provided on the support.

It is also preferred that the cleaning sheet comprises an adhesive layer provided on the side opposite to the adhesive layer, wherein the support has the cleaning layer provided on one side thereof.

It is also preferred that the cleaning layer comprises a heat-resistant polymer resin.

The aforementioned Si-containing fragment ions are represented by the following chemical formulae:
(1) CH₃Si⁺:
   CH₃-Si⁺
(2) C₃H₉Si⁺: 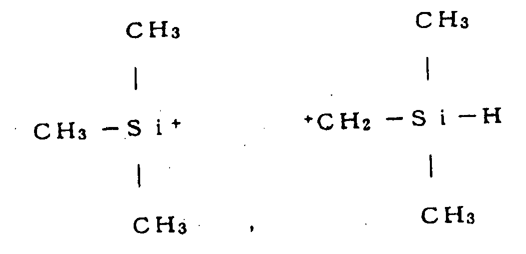
(3) C₅H₁₅Si₂O⁺: 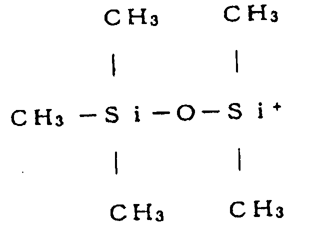
(4) C₅H₁₅Si₃O₃⁺ : 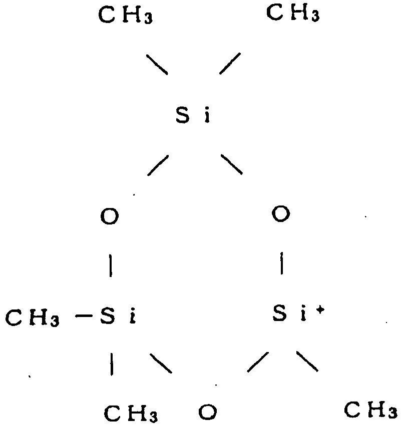
(5) C₇H₂₁Si₃O₂⁺ : 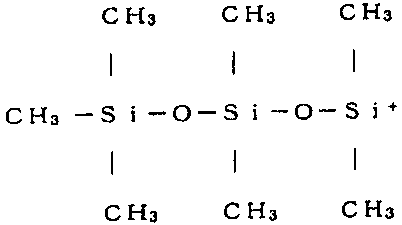
(6) CH₃SiO⁻ : 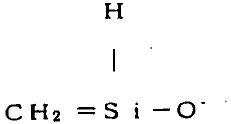
(7) CH₃SiO₂⁻:

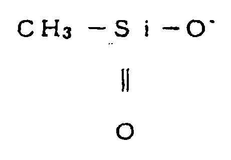

In some detail, the aforementioned fragment ions indicate CH₃Si⁺, C₃H₉Si⁺, C₅H₁₅Si₂O⁺, C₅H₁₅Si₃O₃⁺, C₇H₂₁Si₃O₂⁺, CH₃SiO⁻, CH₃SiO₂⁻ and Si⁺. According to the present invention each of the relative intensities of these ions, relative to C₂H₃⁺ in the case of positive ion or O⁻ in the case of negative ion, is 0.1 or less, preferably 0.01 or less according to time-of-flight secondary ion mass spectrometry.

The aforementioned limitationmakes it possible to surely prevent the contamination of the substrate processing equipment by silicone which has been moved and transferred thereto during the cleaning of the substrate processing equipment and hence drastically inhibit the occurrence of defectives due to the deterioration of the properties of the device.

On the contrary, a cleaning sheet wherein the relative intensity of the aforementioned specific fragment ions in the cleaning layer developed when the protective film is peeled off the cleaning layer is more than 0.1 is subject to a serious problem that when it is conveyed into the interior of a substrate processing equipment, silicone which has been moved and transferred to the surface of the cleaning layer contaminates the device and hence the product wafer, causing the deterioration of the properties of the device resulting in frequent occurrence of defectives and reduction of yield.

The term "time-of-flight secondary ion mass spectrometry" as used herein indicates a method which comprises allowing ion beam (primary ion) to hit the surface of a solid sample at a high speed in high vacuum to cause sputtering that spring out the surface constituents of the sample so that positively or negatively-charged ions (secondary ions) fly in one direction under an electric field and then detected at a position apart therefrom at a predetermined distance. During sputtering, secondary ions having various masses are generated depending on the composition of the surface of the sample. The smaller the mass of ions, the higher is the rate at which the ions fly.

On the contrary, the more the mass of ions , the lower is the rate at which the ions fly. Therefore, by measuring the time required between the generation and the detection of secondary ions (time-of-flight), the mass of secondary ions thus generated can be calculated.

In the related art mass spectrometry, organic compounds are completely disintegrated during ionization. Thus, data of chemical structure obtained from the mass spectrum run short. On the contrary, the aforementioned analysis method requires a small dose of primary ion beam, making it possible to ionize organic compounds while maintaining its chemical structure and hence determine the structure of the organic compounds from itsmassspectrum. Further, since only secondary ions generated at the outermost part of the surface of the solid sample fly into vacuum, date concerning the outermost surface (depth of about several angstroms) of the sample can be obtained.

Moreover, such an analysis method involving the detection of ions is so sensitive as compared with methods involving the detection of electron or light as to detect components present on the surface of the sample in a trace amount on the order of ppm. By scanning the surface of the sample by primary ion beam, ion image on the surface of the sample can be measured (mapping).

Paying their attention to this time-of-flight secondary ionmass spectrometry, the inventors found that when the relative intensity of the specific fragment ions on the surface of the cleaning layer measured by this time-of-flight secondary ion mass spectrometry is limited to the above defined value or less, the contamination of the device by silicone can be surely prevented.

In the invention, the measurement of the aforementioned relative intensity is made in the following manner.

In the case of a cleaning sheet, the sur face of the cleaning layer from which the protective layer is peeled off, or, in the case of a carrying member with a cleaning function, the surface of the cleaning layer provided therein is subjected to time-of-flight secondary ion mass spectrometry with use of a Type TRIFT II time-of-flight secondary ion mass spectrometer produced by ULVAC-PHI, INC., with measuring conditions of ⁶⁹Ga+ as primary ion, an accelerating voltage of 15 kV and a measuring area of 100 µm square, whereby an electron gun is used for the correction of electrification. The relative intensities of the individual fragment ions are then determined relative to C₂H₃⁺ for positive ion or O⁻ for negative ion.

In order to limit the relative intensity of the aforementioned specific fragment ions in the cleaning layer as defined above in the invention, it is necessary that, in the case of a cleaning sheet, as a protective film to be laminated on the cleaning layer there is used a film having a reduced content of the aforementioned ions, not to mention reducing the amount of the aforementioned ions to be contained in the cleaning layer itself. In other words, as the protective film used in the invention, there is used one which has not been subjected to releasability-providing treatment with a silicone-based release agent, or one which has been subjected to_ releasability-providing treatment with a silicone-based release agent in a limited amount so as to reduce the amount of the aforementioned ions.

In other words, as the protective film used in the invention there is used one which has not been subjected to releasability-providing treatment with a silicone-based release agent or one which has been subjected to releasability-providing treatment with a silicone-based release agent in a limited amount or under limited other conditions.

In the invention, as such a protective film there is preferably used a polyolefin-based film such as polyethylene, polypropylene, polybutene, polybutadiene and polymethylpentene, which is releasable even when not subjected to releasability-providing treatment. Further, a film which has been treated with any of various release agents such as silicone-based, long-chain alkyl-based, fluorine-based, aliphatic acid amide-based and silica-based release agents may be used. In the treatment with a silicone-based release agent or the like, the amount of the release agent is adjusted to limit the relative intensity of the aforementioned specific fragment ions moved and transferred to the cleaning layer to the above defined range.

It is preferred that the thickness of the protective film be normally from 10 µm to 100 µm. Examples of the film to be treated with the aforementioned release agent include those made of resin such as polyvinyl chloride, polyvinyl chloride copolymer, polyethylene terephthalate, polybutylene terephthalate, polyurethane, ethylene-vinyl acetate copolymer, ionomer resin, ethylene-(meth)acrylic acid copolymer, ethylene-(meth)acrylic acid ester copolymer, polystyrene and polycarbonate.

The carrying member with a cleaning function of the invention, comprises a carrying member and a cleaning layer provided on at least one side thereof, wherein the time required until the degree of vacuum in a chamber which has been temporarily reduced from 3.99 10⁻⁸ Pa (3 x 10⁻¹⁰ torr) when the carryingmember is put therein at a temperature of 50°C is returned to 1.33 10⁻⁷ Pa (1 x 10⁻⁹ torr), i.e., time required until the degree of vacuum in the vacuum chamber which has been temporarily reduced when the carrying member is put therein at the aforementioned predetermined temperature is returned almost to the original value is 100 minutes or less, preferably 50 minutes or less after putting the carrying member in the chamber.

When such a carrying member with a cleaning function is used, extreme reduction of the degree of vacuum in a high vacuum substrate processing equipment developed when it is conveyed into the substrate processing equipment can be inhibited and defects such as suspension of the operation of the device can be prevented, making it possible to simply and surely remove foreign matters from the interior of the processing device.

However, when a carrying member with a cleaning function wherein the time required until the original degree of vacuum is almost reached is more than 100 minutes after putting the carrying member in the chamber is conveyed into a high vacuum substrate processing equipment, water content contained in the cleaning layer, etc. is evaporated to reduce the degree of vacuum in the device. Consequently, it takes much time for the device to recover the initial degree of vacuum. In the worst case, problems such as suspension of the operation of the device can occur.

For the measurement of the time required for the device to substantially recover the original degree of vacuum herein, a Type EMD-WA1000S temperature programmed desorption mass spectrometer produced by DENSHIKAGAKU KOGYO INC. was used on a carrying member with a cleaning function as a sample. Referring to the measuring conditions, the temperature in the chamber was kept at 50°C. The size of the sample was 1 cm². The initial degree of vacuum in the chamber was 3.99 10⁻⁸ Pa (3 x 10⁻¹⁰ torr). Under these conditions, the time required for the device to recover 1.33 10⁻⁷ Pa (10⁻⁹ torr) was determined as vacuum recovery time.

The material constituting the carrying member with a cleaning function of the invention is not specifically limited so far as it is arranged such that the vacuum recovery time is limited to the above defined range. In general, a material capable of reducing the content of volatile component such as aliphatic component, aromatic component, solvent component and plasticizer component contained in the cleaning layer as well as reducing the ordinary state moisture absorption of the cleaning layer, particularly to 1% by weight or less is preferably used.

In order to obtain the aforementioned ordinary state moisture absorption, the aforementioned carrying member is preferably subjected to heat dehumidification under conditions that the properties thereof are not impaired, e.g., at a temperature of from 40°C to 200°C, preferably from 50°C to 150°C, more preferably from 50°C to 100°C for 1 to 120 minutes, preferably 1 to 60 minutes. Further, in order to reduce the absolute water content, the thickness of the cleaning layer is preferably reduced, more preferably to a range of 1 to 30 µm so far as the properties of the cleaning layer are not impaired.

In the invention, the cleaning layer is not specifically limited but is preferably made of a material having a tensile modulus of 10 Mpa or more, more preferably from 10 to 2,000 Mpa as determined according to JIS K7127. When the tensile modulus of the material is 10 MPa or more, protrusion or malcutting of the cleaning layer during label cutting can be inhibited, making it possible to produce a contaminant-free label sheet with a cleaning function in a precutting process.

Further, the resulting label sheet cannot be stuck to contact portions in the device and cause conveyance troubles when conveyed into the device. On the contrary, when the tensile modulus of the material is 2,000 MPa or less, the resulting label sheet can fairly remove foreign matters from the conveyance system.

The material of the cleaning layer is not specifically limited but is preferably made of a resin layer polymerization-cured by an activated energy source such as ultraviolet rays and heat. This is because the aforementioned polymerization curing causes the three-dimensional networking of the molecular structure of the resin resulting in substantial loss of tack of the resin. As a result, a cleaning member can be obtained which is not firmly stuck to the contact portions in the device when conveyed into the device and thus can surely be conveyed through the interior of the substrate processing equipment.

The term "substantially no adhesive strength" as used herein is meant to indicate that there is no pressure-sensitive tack representing the function of adhesion, supposing that the essence of tack is friction which is resistance to sliding. This pressure-sensitive tack occurs when the elastic modulus of the tacky material is 1 MPa or less according, e.g., to Dahlquist's standard.

Examples of the aforementioned polymerization-cured resin layer include those obtained by curing a curable resin composition comprising a pressure-sensitive polymer compound having one or more unsaturated double bonds per molecule (hereinafter referred to as "polymerizable unsaturated compound"), a polymerization initiator and optionally a crosslinking agent or the like by an activated energy source, particularly ultraviolet rays.

Examples of the pressure-sensitive polymer include acrylic polymers obtained from (meth)acrylic acid and/or (meth)acrylic acid ester as a main monomer. For the synthesis of this acrylic polymer, a compound having two or more unsaturated double bonds per molecule may be used as a copolymerizable monomer or may be chemically bonded to the acrylicpolymer thus synthesized by reaction between functional groups to introduce unsaturated double bonds into the acrylic polymer molecule. The introduction of unsaturated double bonds allows the acrylic polymer itself to take part in the polymerization-curing reaction.

The polymerizable unsaturated compound to be used herein preferably is nonvolatile and has a weight-average molecular weight of 10,000 or less. In particular, the polymerizable unsaturated compound preferably has a molecular weight of 5, 000 or less so that when cured, it can undergo efficient three-dimensional networking.

Examples of the aforementioned polymerizable compound include phenoxypolyethylene glycol (meth)acrylate, e-caprolactone (meth)arylate, polyethylene glycol di(meth)acrylate, polypropylene glycol di(meth)acrylate, trimethylolpropane tri(meth)acrylate, dipentaerythritol hexa(meth)arylate, urethane (meth)acrylate, epoxy (meth)acrylate, and oligoester (meth)acrylate. One or more of these polymerizable compounds may be used.

The polymerization initiator to be used herein is not specifically limited and may be selected from a wide range of polymerization initiators.

For example, in the case where heat is used as an activated energy source, a heat polymerization initiator such as benzoyl peroxide and azobisisobutylonitrile may be used. In the case where light is used as an activated energy source, a photopolymerization initiator such as benzoyl, benzoin ethyl ether, dibenzyl, isopropyl benzoin ether, benzophenone, Michler's ketone chlorothioxanthone, dodecylthioxanthone, dimethylthioxanthone, acetophenone diethyl ketal, benzyl dimethyl ketal, α-hydroxycyclohexylphenyl ketone, 2-hydroxymethylphenyl propane and 2,2-dimethoxy-2-phenyl acetophenone.

In addition, in the invention a heat-resistant high polymer resin can also be used for the cleaning layer. With respect to heat-resistant polymer resins, they are not specifically limited so long as they are provided with heat-resistance, and include, for example, a polyimide resin obtained by thermal imidization of a polyamic acid resin having the structural unit represented by the following formula (1) in its main chain. 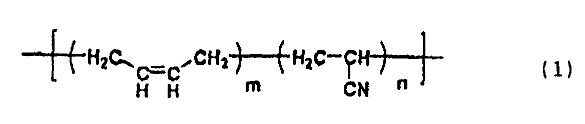 (n and m each represents an integer of 0 or more with the condition that either of n or m is an integer not smaller than 1.)

The above-cited polyamic acid resin can be obtained by reacting a tetracarboxylic dianhydride component with a diamine component at substantially an equi-molar ratio in an appropriate organic solvent.

The aforementioned tetracarboxylic dianhydride component includes, for example, 3,3',4,4'-biphenyltetracarboxylic dianhydride, 2,2',3,3'-biphenyltetracarboxylic dianhydride, 3,3',4,4'-benzophenonetetracarboxylic dianhydride, 2,2',3,3'- benzophenonetetracarboxylic dianhydride, 4,4'-oxydiphthalic dianhydride, 2,2-bis(2,3-dicarboxyphenyl)hexafuloropropane dianhydride, 2,2-bis(3,4-dicarboxyphenyl)hexafuloropropane dianhydride (6FDA), bis(2,3-dicarboxyphenyl)methane dianhydride, bis(3,4-dicarboxyphenyl)methane dianhydride, bis(2,3-dicarboxyphenyl)sulfone dianhydride, bis(3,4-dicarboxyphenyl)sulfone dianhydride, pyromellitic dianhydride, ethylene glycol bistrimellitic dianhydride, etc. These compounds may be used individually or in combination of two or more thereof.

And, as the aforementioneddiamine component, the diamine having a structure represented by the formula (1), exemplified by the aliphatic diamine represented by the following formula (2) or the following formula (3) is characteristically used. Such a diamine is used alone or in combination with other plural diamines. The diamine to be used in combination includes, for example, 4,4'-diaminodiphenyl ether, 3,4'-diaminodiphenyl ether, 3,3'-diaminodiphenyl ether, m-phenylenediamine, p-phenylenediamine, 4,4'-diaminodiphenylpropane, 4,4'-diaminodiphenylmethane, 3,3'-diaminodiphenylpropane, 4,4'-diaminodiphenylsulfide, 3,3'-diaminodiphenylsulfide, 4,4'-diaminodiphenylsulfone, 3,3'-diaminodiphenylsulfone, 1,4-bis(4-aminophenoxy)benzene, 1,3-bis(4-aminophenoxy)benzene, 1,3-bis(3-aminiphenoxy)benzene, 1,3-bis(4-aminophenoxy)-2,2-dimethylpropane, hexamethylenediamine, 1,8-diaminoocatane, 1,12-diaminododecane, 4,4'-diaminobenzophenone, 1,3-bis(3-aminopropyl)-1,1,3,3-tetramethyldisiloxane, etc. 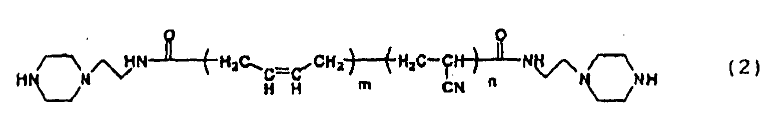 (m, n represents an integer of 0 or larger.) 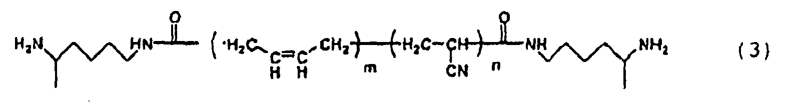 (m, n represents an integer of 0 or larger.)

Such a tetracarboxylic dianhydride and a diamine can be reacted at substantially an equi-molar ratio in an appropriated organic solvent. And, in particular, when a diamine having the structure represented by the formula (1), gel formation can be prevented by adopting a reaction temperature of 100°C or higher. When the polymerization is carried out at a temperature lower than these temperatures, adifficultyoccurs in some cases that the removal of foreign matters by filtration becomes difficult due to the clogging caused by the gel remaining in the reaction system depending on the use amount of the diamine.

In addition, since the reactionproceeds heterogeneously, such gel sometimes acts to cause the properties of the resulting resin to fluctuate.

The appropriate solvent used for the reaction of the aforementioned tetracarboxylic dianhydride with the aforementioned diamine includes N,N-dimethylacetamide, N-methyl-2-pyrrolidone and N,N-dimethylformamide. These solvents can be used by suitably mixing with a non-polar solvent such as toluene or xylene in order to regulate the solubility of the feedstock materials as well as the resulting resin.

The polyimide resin used in the invention can be prepared via thermal imidization of the polyamic acid resin prepared by the above-described process. As the method of thermal imidization, there may be adopted one in which imidization is conducted in a solvent by azeotropic dehydration process whereby an azeotropic solvent with water such as toluene, xylene, etc. is mixed in the solution of the aforementioned polyamic acid, or another one in which the polyamic acid is coated on a substrate followed by solvent drying and heat treatment for imidization.

As the material other than the polyimide resin, ladder polymers such as phenyl-T, polyquinoxaline, or polybenzoylenebenzimidazole, and aromatic polymers such as polyphenylene, polyamide, polyester imide, polybenzimidazole, polycarbodiimide, or aramide, can also be used for the cleaning layer.

In particular, polyimides, polyamides and polycarbodiimides are suited for the cleaning layer since they do not generate any volatile gas or decomposed monomer even when exposed to an elevated temperature above 400°C. In the case where a cleaning member containing such a heat-resistant material is used for those apparatuses which are operated under elevated temperatures such as an ozone asher, a resist coater, an oxidation diffusing furnace, an ambient pressure CVD apparatus, a reduced pressure CVD apparatus and a plasma CVD apparatus, etc., the cleaning member can be used without causing poor transport or contamination during the transport inside the processing apparatus.

The method of forming a cleaning layer comprising such a heat-resistant resin is not specifically limited. The cleaning layer may be directly coated on a releasable layer on an appropriate carrying member by, for example, spin coating or spray coating, ormaybe first formed on a PET filmor polyimide film by comma-coating or gravure coating, and then transferred or laminated onto a releasable layer on an appropriate carrying member. The high temperature at which the cleaning member is treated after solvent drying is preferably at least 200°C. And to prevent the oxidative deterioration of the resin, the treatment is preferably carried out under an inert atmosphere such as of nitrogen or vacuum. By such treatment, the volatile ingredient remaining in the resin can be perfectly eliminated. The thickness of the resin, which is not specifically limited, is usually from 5 to 100 µm (preferably from 10 to 50 µm).

The aforementioned cleaning layer exhibits an adhesive strength of 0.2 N/10 mm width or less, preferably from 0.01 to 0.1 N/10 mm width or less when peeled off silicon wafer (mirror surface) at an angle of 180 degrees (as determined according to JIS Z0237). When the cleaning layer thus has little or no adhesive strength, the resulting cleaningmember cannot be stuck to contact portions in the device and causes no conveyance troubles during conveyance.

In the invention, by forming such a cleaning layer singly into a sheet or tape or providing the cleaning layer on a proper support, and then laminating the aforementioned releasable protective film on the cleaning layer, the cleaning sheet of the invention can be prepared. By conveying this cleaning sheet into various substrate processing equipments with the aforementioned protective film peeled off or while being stuck to the carrying member with an adhesive so that the cleaning layer comes in contact with the contact portions in the device, foreign matters attached to the contact portions can be simply and surely removed.

A particularly preferred embodiment of the invention is a cleaning sheet comprising a cleaning layer provided on one side of a support, the aforementioned releasable protective film laminated on the cleaning layer and an adhesive layer provided on the other side of the support.

In this arrangement, the thickness of the support is normally from 10 µm to 100 µm, the thickness of the cleaning layer is normally from 5 µm to 100 µm, and the thickness of the adhesive layer is normally from 5 µm to 100 µm (preferably from 10 µm to 50 µm).

This cleaning sheet is laminated on a carrying member through the adhesive layer provided on the other side of the support to prepare a carrying member with a cleaning function. By conveying this carrying member into various substrate processing equipments with the protective film peeled off the cleaning layer as mentioned above so that the cleaning layer comes in contact with the contact portions, foreign matters attached to the contact portions can be simply and surely removed.

In the invention, such a cleaning layer is singly formed into a sheet or tape. The cleaning layer is provided on at least one side of a carrying member with a proper adhesive. Alternatively, the aforementioned cleaning layer is provided on a support. The cleaning layer is then provided on at least one side of a carrying member through the support.

More preferably, the aforementioned cleaning layer is provided on one side of a support while an adhesive layer is provided on the other. The aforementioned cleaning layer is provided on at least one side of a carrying member through the aforementioned adhesive layer. Thus, the desired carrying member with a cleaning function is produced.

In the case where the cleaning layer comprises a heat-resistant resin, this resin is directly spread over a carrying member such as silicon wafer by a spin coating method, spraying method or the like, and then dried to form a cleaning layer. Alternatively, the aforementioned resin is spread over a support by a comma coating method, fountain method, gravure method or the like, and then dried to form a cleaning layer. The coated material is then laminated on the aforementioned carrying member through the support.

Alternatively, only the cleaning layer is transferred to the carrying member to obtain the desired carrying member with a cleaning function.

A temperature for heating during coating and drying is preferably 200°C or higher. Moreover, it is preferable to treat under inert atmosphere (e.g. nitrogen atmosphere or in vacuo) in order to prevent oxidization and deterioration of a resin. Accordingly, it is possible to completely remove a volatile component remaining in the resin.

In accordance with this carrying member with a cleaning function, the vacuum recovery time as a whole including the cleaning layer is limited to the above defined range. In this arrangement, the carrying member with a cleaning function can be conveyed into various substrate processing equipments, particularly high vacuum substrate processing equipment, without causing extreme reduction of the degree of vacuum in these substrate processing equipments as in the related art and hence troubles with the operation of the device. Thus, by allowing the cleaning layer of the carrying member to come in contact with the contact portions, foreign matters attached to the contact portions can be simply and surely removed.

The support for supporting the cleaning layer is not specifically limited. Examples of the support employable herein include film of polyolefin-based material such as polyethylene, polypropylene, polybutene, polybutadiene and polymethylpentene, and plasticfilm madeofpolyvinylchloride, vinyl chloride copolymer, polyethylene terephthalate, polybutylene terephthalate, polyurethane, ethylene-vinyl acetate copolymer, ionomer resin, ethylene- (meth) acrylic acid copolymer, ethylene- (meth)acrylic acid ester copolymer, polystyrene, or polycarbonate.

Particularly preferred among these materials are polyolefin-based film and ethylene-vinyl acetate copolymer film because they have a low hygroscopicity. These supports may be used singly or in combination of two or more thereof. Further, these supports may be subjected to surface treatment such as corona treatment on one or both sides thereof.

The adhesive layer to be provided on the other side of the support is not specifically limited in its material and may be made of an ordinary adhesive such as acrylic adhesive and rubber-based adhesive. Among these adhesives, an adhesive comprising an acrylic polymer having components having a weight-average molecular weight of 100,000 or less in a proportion of 10% by weight or less as a main component is preferably used as an acrylic adhesive.

The aforementioned acrylic polymer can be synthesized by subjecting a monomer mixture comprising a (meth) acrylic acid alkyl ester as a main monomer and optionally other copolymerizable monomers to polymerization reaction.

The thickness of the adhesive layer is preferably from 5 µm to 100 µm, particularly from 5 µm to 20 µm to reduce the absolute water content thereof.

The adhesive layer exhibits an adhesive strength of from 0.01 to 10 N/10 mm width, preferably from 0.05 to 5 N/10 mm width or less when peeled off silicon wafer (mirror surface) at an angle of 180 degrees.

When the adhesive strength of the adhesive layer is too high, the support can be torn when the cleaning layer is peeled off the carrying member through the support.

In the invention, a protective layer may be laminated on the cleaning layer and the adhesive layer to protect these layers.

Examples of the protective film employable herein include plastic films such as polyvinyl chloride film, vinyl chloride copolymer film, polyethylene terephthalate film, polybutylene terephthalate film, polyurethane film, ethylene-vinyl acetate copolymer film, ionomer resin film, ethylene-(meth)acrylic acid copolymer film, ethylene-(meth)acrylic acid ester copolymer film, polystyrene film and polycarbonate film treated with a releasability-providing agent such as silicone-based, long-chainalkyl-based, fluorine-based, aliphatic amide-based and silica-based releasability-providing agents. Films made of polyolefin-based resin such as polyethylene, polypropylene, polybutene, polybutadiene and polymethyl pentene may be used as a protective film themselves because they stay releasable without any releasability-providing agent.

The thickness of the protective film made of these materials is preferably from about 10 µm to 100 µm.

The carrying member used for the carrying member with a cleaning function in accordance with the invention is selected from the group consisting of semiconductor wafers, bases for flat panel display such as LCD and PDP, and bases for compact disc and MR head.

Since the carrying member with a cleaning function of the invention is designed to inhibit the reduction of the degree of vacuum, the substrate processing equipment to be cleaned using this carrying member is preferably a high vacuum substrate processing equipment.

However, the carrying member with a cleaning function of the invention may be applied to other various substrate processing equipments. Specific examples of these substrate processing equipments include exposure device, resist coating device, developing device, ashing device, dry etching device, ion injecting device, PVD device, CVD device, external appearance detecting device, and wafer prober.

The invention also provides the aforementioned various substrate processing equipments cleaned by conveying the carrying member with a cleaning function of the invention.

### EXAMPLES

The invention will be further described in the following examples. The term "parts" as used hereinafter is meant to indicate "parts by weight".

### Example 1

100 parts of an acrylic polymer A (weight-average molecular weight: 700, 000) obtained from a monomer mixture of 75 parts of 2-ethylhexyl acrylate, 20 parts of methyl acrylate and 5 parts of acrylic acid were uniformly mixed with 200 parts of a polyethylene glycol 200 dimethacrylate (trade name: NK Ester 4G, produced by Shin-nakamura Chemical Corporation), 3 parts of a polyisocyanate compound (trade name: Colonate L, produced by NIPPON POLYURETHANE INDUSTRY CO., LTD.) and 2 parts of benzyl dimethyl ketal (trade name: Irgacure 651, produced by Ciba Specialty Chemicals, Inc.) as a photopolymerization initiator to prepare an ultraviolet-curing resin composition A.

Separately, into a 500 ml three-necked flask reactor equipped with a thermometer, a stirrer, a nitrogen intake pipe and a reflux condenser were charged 73 parts of 2-ethylhexyl acrylate, 10 parts of n-butyl acrylate, 15 parts of N, N-dimethyl acrylamide, 5 parts of acrylic acid, 0.15 parts of 2,2'-azobisisobutylonirile as a polymerization initiator and 100 parts of ethyl acetate to make 200 g. Nitrogen gas was then introduced into the reactor with stirring for about 1 hour to replace air within the reactor by nitrogen.

Thereafter, the interior of the reactor was kept at a temperature of 58°C for about 4 hours to cause polymerization resulting in the production of an adhesive polymer solution. 100 parts of the polymer solution were then uniformly mixed with 3 parts of a polyisocyanate compound (trade name: Colonate L, produced by NIPPON POLYURETHANE INDUSTRY CO., LTD.) to prepare an adhesive solution A.

The aforementioned adhesive solution A was spread over a separator A made of a polyester film of continuous length (trade name: MRF50N100, produced by MITSUBISHI POLYESTER FILM CORPORATION; thickness: 50 µm; width: 250 mm) one side of which had been treated with a silicone-based releasability-providing agent on the silicone-treated surface thereof to a dry thickness of 15 µm, and then dried. A polyester film of continuous length (thickness: 25 µm; width: 250 mm) was then laminated on the adhesive layer as a support. The aforementioned ultraviolet-curing resin composition A was then spread over the support to a thickness of 30 µm to provide a resin layer thereon. At the same time, a releasable protective film A made of a biaxially-stretched polypropylene film of continuous length (trade name: Torayfan BO2500 produced by Toray Industries, Inc.; thickness: 30 µm; width: 250mm) was laminated on the surface of the resin layer to provide a laminated sheet A.

The laminated sheet A was then irradiated with ultraviolet rays having a central wavelength of 365 nm at an integrated dose of 1,000 mJ/cm² to prepare a cleaning sheet A comprising a cleaning layer made of a polymerization-cured resin layer. The cleaning sheetAwas thenmeasured for a peeling adhesive strength when the protective film A is peeled off the cleaning layer at an angle of 180° with respect to silicon wafer (mirror surface) according to JIS Z0237. As a result, the peeling adhesive strength of the cleaning sheet A was found to be 0.06 N/10 mm. The tensile strength (tensile modulus: measured according to JIS K7127) of the cleaning layer was 440 MPa.

The relative intensity of specific fragment ions in the aforementioned cleaning layer, relative to C₂H₃⁺ in the case of positive ion or O⁻ in the case of negative ion, were measured using a Type TRIFTII time-of-flight secondary ion mass spectrometer produced by ULVAC-PHI, INC.

As a result, the relative intensities of CH₃Si⁺, C₃H₉Si⁺, C₅H₁₅Si₂O⁺, C₅H₁₅Si₃O₃⁺, C₇H₂₁Si₃O₂⁺, CH₃SiO⁻, CH₃SiO₂⁻ and Si⁺ were found to be 0.002, 0.0012, 0.00072, 0.00013, 0.00014, 0. 00003, 0.000012 and 0.003, respectively.

The separator A was peeled off the cleaning sheet A on the adhesive layer side thereof. The cleaning sheet A was then stuck to the mirror surface of a 20,32- cm (8-inch) silicon wafer using a hand roller to prepare a carrying member A with a cleaning function. The 180° peeling adhesive strength of the aforementioned adhesive layer with respect to silicon wafer (mirror surface) was 1.5 N/10 mm width.

Using a laser surface detector, three sheets of brand-new 20,32 cm (8-inch) silicon wafers were measured for the presence of foreign matters having a size of 0.2 µm or more on the mirror surface thereof. As a result, the two sheets of silicon wafers were found to have 5, 10 and 3 pieces of foreign matters having such a size, respectively. These silicon wafers were conveyed into a resist exposure device having separate vacuum suction mechanisms with its mirror surface facing downward, and then detected by the laser surface detector on the mirror surface thereof.

As a result, the two sheets of silicon wafers were found to have 1, 523, 1, 498 and 1671 pieces of foreign matters having a size of 0.2 µm or more present on the area of 8 inch wafer size, respectively.

The protective film A was peeled off the carrying member A with a cleaning function on the cleaning layer side thereof. The carrying member A with a cleaning function was then conveyed into the resist exposure having the wafer stage to which 1, 523 pieces of foreign matters had been attached. As a result, conveyance was conducted without any troubles. This procedure was conducted five times. Thereafter, a brand-new 8-inch silicon wafer was conveyed with its mirror surface facing downward. The silicon wafer was then measured for the presence of foreign matters having a size of 0.2 µm or more on the mirror surface thereof using the laser surface detector. As a result, it was found that 90% of the initial amount of foreign matters had been removed.

Thereafter, the product wafer was processed. As a result, the product wafer was not contaminated by silicone, demonstrating that a product wafer can be prepared without any problems.

### Example 2

A polyamic acid solution B to be used as the resin for the cleaning layer was prepared by mixing and reacting 30.0 g of ethylene-1,2-bistrimellitate tetracarboxylic dianhydride (abbreviated as TMEG hereinafter) with 65.8 g of a diamine represented by the formula (2) (amine equivalent: 900, content of acrylonitrile: 18%) and 15.0 g of 2,2'-bis[4-(4-aminophenoxy)phenyl]propane (abbreviated as BAPP hereinafter) in 110 g of N-methyl-2-pyrrolidone (abbreviated as NMP hereinafter) under nitrogen gas stream, and then cooling.

The polyamic acid solution B was coated on an 20,32- cm (8-inch) silicon wafer so as to give a thickness after drying of 30 µm by spin coating, and the coating was dried at 90°C for 10 min. This product was heat-treated at 300°C for 2 hr in a nitrogen atmosphere to give a carrying member B with a cleaning function. In addition, polyamic acid B was coated on a polyimide film by fountain process so as to give a thickness after drying of 30 µm, and the coating was dried at 90°C for 10 min. This product was heat-treated at 300°C for 2 hr in a nitrogen atmosphere to give a sheet B having a cleaning resin layer.

The adhesive force for 180° peeling off of the cleaning layer side of sheet B from the silicon wafer (mirror surface) was measured (in conformity with JIS Z0237) to give a value of 0.02 N/10 mm. And the tensile strength (tensile modulus being measured in conformity with the testing method JIS K7127) was 200 MPa.

Further, the relative intensities (relative to C₂H₃⁺ for positive ion, and O⁻ for negative ion) of the specified fragment ions in the aforementioned cleaning layer were measured with use of a time-of-flight secondary ion mass spectrometer (Type TRIFT II produced by ULVAC-PHI, INC.).

The results were as follows:
CH₃Si⁺: 0.01, C₃H₉Si⁺: 0.005, C₅H₁₅rSi₃O⁺: 0.003, C₅H₁₅Si₃O₃⁺:
   0.001, C₇H₂₁Si₃O₂⁺: 0.001, CH₃SiO⁻: 0.005, CH₃SiO₂-: 0.001, and Si⁺: 0.02

The protective film A laminated on the cleaning layer side of the carrying member B with a cleaning function was peeled off the carrying member B. And, the carrying member B with a cleaning function was then conveyed into the resist exposure unit having the aforementioned wafer stage to which 1, 671 pieces of foreign matters had been attached. As a result, smooth conveyance was conducted without any trouble. This procedure was repeated five times. Thereafter, a brand-new 20,32- cm (8-inch) silicon wafer was conveyed with its mirror surface facing downward. The silicon wafer was then measured for the presence of foreign matters having a size of 0.2 µm or more with use of a laser foreign matter inspection apparatus. As a result, it was found that 92% of the initial amount of foreign matters had been removed.

Thereafter, a product wafer was processed whereby the product wafer was not contaminated by silicone, demonstrating that a product wafer can be prepared without any problem.

### Comparative Example 1

A laminated sheet C was prepared in the same manner as in Example A except that the releasable protective film A to be provided on the cleaning layer was replaced by a releasable protective film B made of a polyester film of continuous length (trade name: MRF25N100, produced by MITSUBISHI POLYESTER FILM CORPORATION; thickness: 25 µm; width: 250 mm) one side of which had been treated with a silicone-based releasability-providing agent. The laminated sheet C was then irradiated with ultraviolet rays in the same manner as in Example 1 to prepare a cleaning sheet C. The cleaning sheet C was then processed in the same manner as in Example 1 to prepare a carrying member C with a cleaning function.

The protective film B was peeled off the cleaning sheet C on the cleaning layer side thereof. The relative intensities of specific fragment ions in the cleaning layer, relative to C₂H₃⁺ in the case of positive ion or O⁻ in the case of negative ion, were then measured in the same manner as mentioned above.

As a result, the relative intensities of CH₃Si⁺, C₃H₉Si⁺, C₅H₁₅Si₂O⁺, C₅H₁₅Si₃O₃⁺, C₇H₂₁Si₃O₂⁺, CH₃SiO⁻, CH₃SiO₂⁻ and Si⁺ were found to be 0.93, 0.15, 1.2, 0.35, 0.37, 0.0064, 0.0033 and 2.9, respectively.

Subsequently, the protective film B was peeled off the carrying member C with a cleaning function on the cleaning layer side thereof. The carrying member C with a cleaning function was then conveyed into the resist exposure having the wafer stage to which 1, 498 pieces of foreign matters hadbeen attached. As a result, conveyance was conducted without any troubles. This procedure was conducted five times. Thereafter, a brand-new 20,32 cm (8-inch) silicon wafer was conveyed with its mirror surface facing downward. The silicon wafer was then measured for the presence of foreign matters having a size of 0.2 µm or more on the mirror surface thereof using the laser surface detector. As a result, it was found that 70% of the initial amount of foreign matters had been removed.

However, when the product wafer was then processed, it was contaminated because the device had been contaminated by silicone. As a result, defectives often occurred due to the deterioration of the properties of the device. Therefore, in order to remove silicone contaminants from the device, it took much labor to suspend the operation of the device, open the device and clean the device.

### Example 3

The protective film was peeled off a cleaning sheet A prepared in the same manner as in Example 1 on the adhesive layer side thereof. The cleaning sheet A was then stuck to the mirror surface of a 20,32 cm (8-inch) silicon wafer to prepare a carrying member A with a cleaning function. The 180° peeling adhesive strength of the aforementioned adhesive layer with respect to silicon wafer (mirror surface) was 1.5 N/10 mm width.

The protective film was peeled off the carrying member A with a cleaning function on the cleaning layer side thereof. The vacuum recovery time was then measured using a Type EMD-WA1000S temperature programmed desorption mass spectrometer produced by DENSHIKAGAKU KOGYO INC. The result was 50 minutes.

Using a laser surface detector, three sheets of 20,32 cm (8-inch) silicon wafers were then measured for the presence of foreign matters having a size of 0.2 µm or more on the mirror surface thereof. As a result, the three sheets of silicon wafers were found to have 10, 3 and 5 pieces of foreign matters having such a size present on the mirror surface thereof, respectively.

Subsequently, these wafers were conveyed into separate sputtering devices having an electrostatic suction mechanism with a vacuum degree of 1.33 10⁻⁷ Pa (10⁻⁹ torr) with its mirror surface facing downward. Using the laser surface detector, these silicon wafers were again measured for the presence of foreign matters on the mirror surface thereof.

As a result, these silicon wafers were found to have 15, 553, 16,643 and 14,961 pieces of foreign matters having a size of 0.2 µm or more present on the area of 20,32 cm (8-inch) wafer size, respectively.

Subsequently, the protective film was peeled off the carrying member A with a cleaning function on the cleaning layer side thereof. The carrying member A with a cleaning function was then conveyed into the sputtering device having the wafer stage to which 15, 553 pieces of foreign matters had been attached. As a result, conveyance was conducted with the vacuum degree in the device kept at 1.33 10⁻⁷ Pa (10⁻⁹ torr) without any troubles. This procedure was conducted five times. Thereafter, a brand-new 20,32 cm (8-inch) silicon wafer was conveyed with its mirror surface facing downward. The silicon wafer was then measured for the presence of foreign matters having a size of 0.2 µm or more on the mirror surface thereof using the laser surface detector. As a result, it was found that 90% of the initial amount of foreign matters had been removed.

Thus, the degree of vacuum in the sputtering device showed no drop during the conveyance of the carrying member A with a cleaning function into the device. Accordingly, this device can be cleaned without any troubles in the operation of the device.

### Example 4

The adhesive solution A prepared in Example 1 was spread over the silicone-treated surface of the same protective film (MRF50N100) as used in Example 1 to a dry thickness of 15 µm. A polyester film of continuous length (thickness: 50 µm; width: 250 mm) was then laminated on the adhesive layer as a support. The ultraviolet-curing resin composition A prepared in Example 1 was then spread over the film to a dry thickness of 30 µm to provide a resin layer. The same protective film as used above was then laminated on the surface of the resin layer with its silicone-treated side thereof thereinside to prepare a laminated sheet B.

The laminated sheet B was then processed in the same manner as in Example 2 to prepare a cleaning sheet B and a carrying member B with a cleaning function. Subsequently, the protective f ilmwas peeled of f the carrying member B with a cleaning function on the cleaning layer. The carrying member B with a cleaning function was then subjected to heat treatment at 90°C for 10 minutes. Thereafter, the vacuum recovery time of the carrying member B with a cleaning function was measured. The result was 30 minutes.

Subsequently, the protective film was peeled off the carrying member B with a cleaning function on the cleaning layer side thereof. The carrying member B with a cleaning function was then conveyed into the sputtering device having the wafer stage to which 16,643 pieces of foreign matters had been attached.

As a result, conveyance was conducted with the vacuum degree in the device kept at 1.33 10⁻⁷ Pa (10⁻⁹ torr) without any troubles. This procedure was conducted five times. Thereafter, a brand-new 20,32 cm (8-inch) silicon wafer was conveyed with its mirror surface facing downward. The silicon wafer was then measured for the presence of foreign matters having a size of 0.2 µm or more on the mirror surface thereof using the laser surface detector. As a result, it was found that 93% of the initial amount of foreign matters had been removed.

Thus, the degree of vacuum in the sputtering device showed no drop during the conveyance of the carrying member B with a cleaning function into the device. Accordingly, this device can be cleaned without any troubles in the operation of the device.

### Comparative Example 2

The adhesive solution A prepared in Example 1 was spread over the same protective film (MRF50N100) as used in Example 1 on the silicone-treated surface thereof to a dry thickness of 30 µm. A polyester film of continuous length (thickness: 50 µm; width: 250 mm) was then laminated on the adhesive layer as a support. The ultraviolet-curing resin composition A prepared in Example 1 was then spread over the polyester film to a dry thickness of 60 µm to provide a resin layer. At the same time, the same protective film as mentioned above was laminated on the surface of the resin layer with its silicone-treated side thereof thereinside to prepare a laminated sheet C.

The laminated sheet C was then processed in the same manner as in Example 2 to prepare a cleaning sheet C and a carrying member C with a cleaning function.

The vacuum recovery time of the carrying member C with a cleaning function was measured in the same manner as in Example 2. The result was 120 minutes.

Subsequently, the protective film was peeled off the carrying member C with a cleaning function on the cleaning layer side thereof. The carrying member C with a cleaning function was then conveyed into the sputtering device having the wafer stage to which 14, 961 pieces of foreign matters hadbeen attached. As a result, the degree of vacuum in the device was reduced from 1.33 10⁻⁷ Pa to 13,33 Pa (10⁻⁹ torr to 10⁻¹ torr) when the first sheet of the carrying member C was conveyed thereinto. The cleaning by the second and following sheets of the carrying member C was then suspended. Thus, the aforementioned carrying member C with a cleaning function caused extreme reduction of the degree of vacuum in the sputtering device when conveyed thereinto, disabling the operation of the device and making it impossible to clean the device.

As mentioned above, the invention is arranged such that the relative intensity of specific fragment ions in the cleaning layer (relative to C₂H₃⁺ in the case of positive ion or O⁻ in the case of negative ion) developed when a releasable protective film is peeled off the cleaning layer during the conveyance into the substrate processing equipment for the removal of foreign matters from the interior thereof each are predetermined to be 0.1 or less as determined by time-of-flight secondary ion mass spectrometry, making it possible to provide a high utility cleaning member which causes less contamination of the device due to the movement and transfer of silicone from the protective film to the cleaning layer.

In accordance with the invention, the vacuum recovery time of the carrying member with a cleaning function during the conveyance into the substrate processing equipment for the removal of foreign matters from the interior thereof is limited to a specific value or less, making it possible to provide a high utility carrying member with a cleaning function which causes little reduction of the degree of vacuum in the device during its conveyance into the device and thus can simply and surely remove foreign matters from the interior of the device.

## Claims

1. A cleaning sheet comprising a cleaning layer and a releasable protective film laminated on the cleaning layer, wherein the cleaning layer is made of a resin layer which has been polymerization-cured by an active energy source, and wherein each of the relative intensities of the fragment ions of CH₃Si⁺, C₃H₉Si⁺, C₅H₁₅Si₂O⁺, C₅H₁₅Si₃O₃⁺, C₇H₂₁Si₃O₂⁺, CH₃SiO⁻, CH₃SiO₂⁻and Si⁺ in the cleaning layer, when the protective film is peeled off the cleaning layer, is 0.1 or less according to time-of-flight secondary ion mass spectrometry, relative to C₂H₃⁺ in the case of positive ion or O⁻ in the case of negative ion.

2. The cleaning sheet according to claim 1, wherein the cleaning layer has substantially no adhesive strength.

3. The cleaning sheet according to claim 1 or 2, which further comprises a support selected from the group consisting of a film of polyolefin-based material, and a plastic film made of polyvinyl chloride, vinyl chloride copolymer, polyethylene terephthalate, polybutylene terephthalate, polyurethane, ethylene-vinyl acetate copolymer, ionomer resin, ethylene-(meth)acrylic acid copolymer, ethylene-(meth)acrylic acid ester copolymer, polystyrene or polycarbonate, wherein the cleaning layer is provided on the support.

4. The cleaning sheet according to claim 3, comprising the cleaning layer provided on one side of the support, the releasable protective film laminated on the cleaning layer, and an adhesive layer provided on the other side of the support.

5. The cleaning sheet according to any one of claims 1 to 4, wherein the cleaning layer comprises a heat-resistant polymer resin.

6. A carrying member with a cleaning function, comprising a carrying base and a cleaning layer provided on at least one side of the carrying base, said carrying base being selected from the group consisting of semiconductor wafers, bases for flat panel displays, and bases for compact disk and MR head, wherein the cleaning layer is made of a resin layer which has been polymerization-cured by an active energy source, and wherein each of the relative intensities of the fragment ions of CH₃Si⁺, C₃H₉Si⁺, C₅H₁₅Si₂O⁺, C₅H₁₅Si₃O₃⁺, C₇H₂₁Si₃O₂⁺, CH₃SiO⁻, CH₃SiO₂⁻ and Si⁺ in the cleaning layer is 0.1 or less according to time-of-flight secondary ion mass spectrometry, relative to C₂H₃⁺ in the case of positive ion or O⁻ in the case of negative ion.

7. The carrying member according to claim 6, wherein the cleaning layer has substantially no adhesive strength.

8. The carrying member according to claim 6 or 7, wherein the cleaning layer comprises a heat-resistant polymer resin.

9. A method of cleaning a substrate processing equipment which comprises conveying a cleaning sheet defined in claim 1, or a carrying member with a cleaning function defined in claim 6 into a substrate processing equipment.

## Patentansprüche

1. Reinigungsfolie umfassend eine Reinigungsschicht und einen auf die Reinigungsschicht laminierten ablösbaren Schutzfilm, wobei die Reinigungsschicht aus einer Harzschicht gebildet ist, die durch Polymerisation durch eine aktive Energiequelle gehärtet worden ist, und wobei die relativen Intensitäten der Fragmentionen von CH₃Si⁺, C₃H₉Si⁺, C₅H₁₅Si₂O⁺, C₅H₁₅Si₃O₃⁺, C₇H₂₁Si₃O₂⁺, CH₃SiO⁻, CH₃SiO₂⁻ und Si⁺ in der Reinigungsschicht, wenn der Schutzfilm von der Reinigungsschicht abgezogen ist, gemäß Time-of-Flight-Sekundärionen-Massenspektrometrie jeweils 0,1 oder weniger betragen, bezogen auf C₂H₃⁺ im Fall eines positiven Ions oder O⁻ im Fall eines negativen Ions.

2. Reinigungsfolie nach Anspruch 1, wobei die Reinigungsschicht im Wesentlichen keine Haftfestigkeit aufweist.

3. Reinigungsfolie nach Anspruch 1 oder 2, welche ferner einen Träger umfasst, der ausgewählt ist aus der Gruppe bestehend aus einer Folie aus Material auf Polyolefinbasis und einer Kunststofffolie, die aus Polyvinylchlorid, Vinylchlorid-Copolymer, Polyethylenterephthalat, Polybutylenterephthalat, Polyurethan, Ethylen-Vinylacetat-Copolymer, lonomerharz, Ethylen-(Meth)acrylsäure-Copolymer, Ethylen-(Meth)acrylsäureester-Copolymer, Polystyrol oder Polycarbonat gebildet ist, wobei die Reinigungsschicht auf dem Träger bereitgestellt ist.

4. Reinigungsfolie nach Anspruch 3, umfassend die auf einer Seite des Trägers bereitgestellte Reinigungsschicht, den auf die Reinigungsschicht laminierten ablösbaren Schutzfilm, und eine auf der anderen Seite des Trägers bereitgestellte Klebeschicht.

5. Reinigungsfolie nach einem der Ansprüche 1 bis 4, wobei die Reinigungsschicht ein wärmebeständiges Polymerharz umfasst.

6. Trägerelement mit einer Reinigungsfunktion, umfassend ein Trägersubstrat und eine auf wenigstens einer Seite des Trägersubstrats bereitgestellte Reinigungsschicht, wobei das Trägersubstrat ausgewählt ist aus der Gruppe bestehend aus Halbleiterwafern, Grundkörpern für Flachbildschirme und Grundkörpern für Compact-Discs und MR-Köpfe, wobei die Reinigungsschicht aus einer Harzschicht gebildet ist, welche durch Polymerisation durch eine aktive Energiequelle gehärtet worden ist, und wobei die relativen Intensitäten der Fragmentionen von CH₃Si⁺, C₃H₉Si⁺, C₅H₁₅Si₂O⁺, C₅H₁₅Si₃O₃⁺, C₇H₂₁Si₃O₂⁺, CH₃SiO⁻, CH₃SiO₂⁻ und Si⁺ in der Reinigungsschicht gemäß Time-of-Flight-Sekundärionen-Massenspektrometrie jeweils 0,1 oder weniger betragen, bezogen auf C₂H₃⁺ im Fall eines positiven Ions oder O⁻ im Fall eines negativen Ions.

7. Trägerelement nach Anspruch 6, wobei die Reinigungsschicht im Wesentlichen keine Haftfestigkeit aufweist.

8. Trägerelement nach Anspruch 6 oder 7, wobei die Reinigungsschicht ein wärmebeständiges Polymerharz umfasst.

9. Verfahren zum Reinigen einer substratbearbeitenden Vorrichtung, umfassend das Befördern einer in Anspruch 1 definierten Reinigungsfolie oder eines in Anspruch 6 definierten Trägerelements mit einer Reinigungsfunktion in eine substratbearbeitende Vorrichtung.

## Revendications

1. Feuille de nettoyage comprenant une couche de nettoyage et un film protecteur détachable stratifié sur la couche de nettoyage, dans laquelle la couche de nettoyage est fabriquée à partir d'une couche de résine qui a été durcie par polymérisation par une source d'énergie active, et dans laquelle chacune des intensités relatives des ions fragments de CH₃Si⁺, C₃H₉Sᵢ⁺, C₅H₁₅Si₂O⁺, C₅H₁₅Si₃O₃⁺, C₇H₂₁Si₃O₂⁺, CH₃SiO⁻, CH₃SiO₂⁻ et Si⁺ de la couche de nettoyage, lorsque le film protecteur est décollé de la couche de nettoyage, est de 0,1 ou moins d'après la spectrométrie de masse des ions secondaires à temps de vol, par rapport au C₂H₃⁺ dans le cas d'un ion positif ou à 0- dans le cas d'un ion négatif.

2. Feuille de nettoyage selon la revendication 1, dans laquelle la couche de nettoyage n'a pratiquement pas de force adhésive.

3. Feuille de nettoyage selon la revendication 1 ou 2, qui comprend en outre un support choisi dans le groupe constitué d'un film en matériau à base de polyoléfine et d'un film plastique en chlorure de polyvinyle, copolymère à base de chlorure de vinyle, téréphtalate de polyéthylène, téréphtalate de polybutylène, polyuréthane, copolymère éthylène-acétate de vinyle, résine ionomère, copolymère éthylène-acide (méth)acrylique, copolymère éthylène-ester d'acide (méth)acrylique, polystyrène ou polycarbonate, dans laquelle la couche de nettoyage est disposée sur le support.

4. Feuille de nettoyage selon la revendication 3, comprenant la couche de nettoyage disposée sur un côté du support, le film protecteur détachable stratifié sur la couche de nettoyage et une couche adhésive disposée sur l'autre côté du support.

5. Feuille de nettoyage selon l'une quelconque des revendications 1 à 4, dans laquelle la couche de nettoyage comprend une résine polymère thermorésistante.

6. Élément porteur ayant une fonction nettoyante, comprenant une base de support et une couche de nettoyage disposée sur au moins un côté de la base de support, ladite base de support étant choisie dans le groupe constitué des plaquettes de semi-conducteurs, des bases pour écrans plats et des bases pour disque compact et tête à magnétorésistance, dans lequel la couche de nettoyage est fabriquée à partir d'une couche de résine qui a été durcie par polymérisation par une source d'énergie active, et dans laquelle chacune des intensités relatives des ions fragments de CH₃Si⁺, C₃H₉Si⁺, C₅H₁₅Si₂O⁺, C₅H₁₅Si₃O₃⁺, C₇H₂₁Si₃O₂⁺, CH₃SiO⁻, CH₃SiO₂⁻ et Si⁺ de la couche de nettoyage est de 0,1 ou moins d'après la spectrométrie de masse des ions secondaires à temps de vol, par rapport au C₂H₃⁺ dans le cas d'un ion positif ou à O⁻ dans le cas d'un ion négatif.

7. Élément porteur selon la revendication 6, dans lequel la couche de nettoyage n'a pratiquement pas de force adhésive.

8. Elément porteur selon la revendication 6 ou 7, dans laquelle la couche de nettoyage comprend une résine polymère thermorésistante.

9. Procédé de nettoyage d'un équipement de traitement de substrat qui comprend le convoyage d'une feuille de nettoyage définie dans la revendication 1, ou d'un élément porteur ayant une fonction nettoyante défini dans la revendication 6 dans un équipement de traitement de substrat.
